# EUROPÄISCHE PATENTSCHRIFT

(11) **EP 1 230 680 B1**
(45) Veröffentlichungstag und Bekanntmachung des Hinweises auf die Patenterteilung: **18.08.2004**
(21) Anmeldenummer: 00988713.4
(22) Anmeldetag: 16.11.2000
(51) Int. Cl.: H01L 23/498, H01L 23/538, H01L 21/98

(54) **VERFAHREN ZUM INTEGRIEREN EINES CHIPS INNERHALB EINER LEITERPLATTE UND INTEGRIERTE SCHALTUNG**
METHOD FOR INTEGRATING A CHIP IN A PRINTED BOARD AND INTEGRATED CIRCUIT
PROCEDE D'INTEGRATION D'UNE PUCE DANS UNE PLAQUETTE ET CIRCUIT INTEGRE

(30) Priorität: 16.11.1999 DE 19954941
(43) Veröffentlichungstag der Anmeldung: 14.08.2002
(73) Patentinhaber: Fraunhofer-Gesellschaft zur Förderung der angewandten Forschung e.V., 80686 München (DE)
(72) Erfinder: JUNG, Erik, 14055 Berlin (DE); OSTMANN, Andreas, 10585 Berlin (DE); LANDESBERGER, Christoph, 82166 Gräfelfing (DE)
(74) Vertreter: Schoppe, Fritz, Dipl.-Ing.
(86) Internationale Anmeldenummer: PCT/EP2000/011380
(87) Internationale Veröffentlichungsnummer: WO 2001/037338

(56) Entgegenhaltungen:
- EP-A- 0 611 129
- US-A- 5 564 181
- PATENT ABSTRACTS OF JAPAN vol. 1996, no. 09, 30. September 1996 (1996-09-30) -& JP 08 115953 A (TOSHIBA CORP), 7. Mai 1996 (1996-05-07)
- PATENT ABSTRACTS OF JAPAN vol. 016, no. 508 (E-1282), 20. Oktober 1992 (1992-10-20) -& JP 04 188642 A (FUJITSU LTD), 7. Juli 1992 (1992-07-07)

## Beschreibung

Allgemein befaßt sich die Erfindung mit der Höchstintegration von elektronischen Elementen oder Elementen von Mikrosystemen oder integrierten Schaltkreisen, auf die im Sinne der vorliegenden Anmeldung als "Chips" Bezug genommen wird, innerhalb von Leiterplatten.

In vielen Bereichen der Mikrosystemtechnik, Elektronik, Sensorik und der Mikroaktorik ergibt sich aus den Produktanforderungen ein Zwang zur steigenden Miniaturisierung und zur Erhöhung der Produktivität durch Zusammenfügung von Teilsystemen in höher integrierten Strukturen. Der Trend zu immer höher integrierten und kompakteren Bauformen führt bereits zur Verwendung ungehäuster Bauelemente, die direkt auf den Modulen angeordnet sind.

Dem zunehmenden Miniaturisierungsdruck auf elektronische Produkte und mikrosystemtechnische Produkte kann nicht mehr allein durch verwendung von ungehäusten Bausteinen entgegengetreten werden. Es besteht daher ein Bedarf an einer Chipintegrationstechnik, die einen höheren Integrationsgrad ermöglicht.

Im Stand der Technik bereits beschrittene Lösungswege zur Erhöhung des Integrationsgrades umfassen beispielsweise die Integration von Komponenten in das Substrat. So wurden bereits große Anstrengungen unternommen, auf Leiterplattenebene beispielsweise gedruckte Widerstände und kapazitive Lagen zu realisieren.

Innerhalb von Keramiksubstraten konnten bereits passive Bauelemente mit guten Toleranzen und akzeptablen elektrischen Werten realisiert werden.

Für einen weitergehenden Integrationsschritt wurde bereits vorgeschlagen, Chips in ein Duromer einzubetten.

Ein weiterer Vorschlag zur Erhöhung der Integrationsdichte besteht in dem Anordnen von Chips innerhalb von Ausnehmungen in der Leiterplatte. Dieser Lösungsvorschlag wird in der Fachwelt teilweise mit dem Schlagwort "chip in cavity" beschrieben.

Die letztgenannten Verfahren zur Erhöhung der Integrationsdichte kamen jedoch meist nicht über das Grundlagenforschungsstadium hinaus, da man für die Durchführung dieser Verfahren Geräte und Materialien benötigte, die in üblichen Herstellungsverfahren nicht zur Verfügung stehen. Ferner war der erzielbare Integrationsgrad noch immer unzureichend.

Die DE 43 33 833 A1 offenbart ein Verfahren zur Herstellung einer dreidimensionalen integrierten Schaltung unter Erreichung hoher Systemausbeuten. Hierzu wird auf ein Trägersubstrat, auf dem eine Isolationsschicht und eine Haftschicht vorgesehen sind, eine Vielzahl von Einzelchips aufgebracht, welche vor dem Aufbringen funktionsmäßig getestet, vereinzelt und rückseitig gedünnt worden sind. Um eine planare Oberfläche zu erhalten, wird über der gesamten Anordnung eine dielektrische Planarisierungsschicht aufgebracht, welche die Einzelchips bedeckt und die Gräben zwischen den Chips ausfüllt. Auf diese Anordnung wird auf gleiche Weise wieder eine Vielzahl von einzelnen Chips aufgebracht. Über dieser zweiten Lage von Chips wird wieder eine dielektrische Planarisierungsschicht aufgebracht. Die Chips der zweiten Lage enthalten bereits beim Aufbringen Durchgangslöcher, welche zur Kontaktierung der Chips der zweiten Lage mit den Chips der ersten Lage verwendet werden.

Die DE 19 642 488 A1 offenbart ein Verfahren zur Kontaktierung von Mikrochips oder Chipkondensatoren und zur Herstellung von Mehrlagen-Dünnschichtleiterplatten. Hierzu wird eine etwa 1,5 mm starke, doppelseitig kupferkaschierte, faserverstärkte FR4- oder FR5-Leiterplatte verwendet und zunächst beidseitig mit Fotoresist beschichtet. Hierauf werden auf beiden Seiten mittels Bohr- und Frästechniken Bauteilsenken, die Ecken der Bauteilsenken sowie die Durchkontaktierungen der Leiterplatte erzeugt. Hierzu wird ein Hochgeschwindigkeits-Leiterplatten-Fräser benötigt, der sich auch hinsichtlich seiner Bohr- bzw. Frästiefe steuern läßt, damit die Senken- und die Ecklöchertiefe der Bauteilstärke angepaßt werden können, um entweder Mikrochips oder aber auch Chipkondensatoren und dergleichen in der Leiterplatte versenken zu können. Nach Abschluß der Fräs- und Bohrarbeiten werden Bauteile mit der Substratoberfläche bündig unter Zugabe von Wärmeleitkleber in die Senken einklebt, wobei die Anschlußflächen der Bauteile nach oben weisen.

Verfahren zur Kontaktierung von Chips auf Substraten sind bekannt aus der JP-A-08 115953 und aus der US-5 564 181.

Ausgehend von diesem Stand der Technik liegt der Erfindung daher die Aufgabe zugrunde, ein für die Höchstintegration geeignetes Verfahren zum Integrieren eines Chips innerhalb einer Leiterplatte sowie eine integrierte Schaltung anzugeben, welche sich mit üblichen Geräten und an sich ihrer Art nach gängigen Verfahrensschritten bewerkstelligen lassen.

Diese Aufgabe wird durch ein Verfahren nach Anspruch 1 oder durch eine integrierte Schaltung nach Anspruch 6 gelöst.

Das erfindungsgemäße Verfahren zum Integrieren eines Chips innerhalb einer Leiterplatte umfaßt folgende Schritte:
- Rückseitiges Dünnen eines ungehäusten Chips mit wenigstens einer Anschlußfläche auf seiner der Anschlußfläche abgewandten Rückseite;
- Aufbringen des ungehäusten Chips mit dessen Rückseite auf eine eine Leiterstruktur aufweisende Leiterplattenbodenschicht;
- Aufbringen einer den ungehäusten Chip umhüllenden weiteren Leiterplattenschicht auf die Leiterplattenbodenschicht;
- Erzeugen von sich durch die weitere Leiterplattenschicht bis zu der Anschlußfläche und zu der Leiterstruktur erstreckenden Ausnehmungen, und
- Aufbringen einer Kontaktierungsleiterstruktur auf weitere Leiterplattenschicht, welche sich bis zu der Anschlußfläche und der Leiterstruktur erstreckt.

Erfindungsgemäß erfolgt bei dem Verfahren zum Integrieren eines Chips innerhalb einer Leiterplatte zunächst ein rückseitiges Dünnen eines ungehäusten Chips mit wenigstens einer Anschlußfläche auf seiner der Anschlußfläche abgewandten Rückseite. Sodann werden die gedünnten, ungehäusten Chips auf eine bereits mit Leiterstrukturen versehene Leiterplattenbodenschicht aufgebracht. Bei dem Chip kann es sich bevorzugt um einen auf seiner den Anschlußflächen gegenüberliegenden Seite gedünnten Chip handeln, der vorzugsweise auf seinen Anschlußflächen mit einer zusätzlichen kontaktierbaren Metalllage versehen ist. Innerhalb der weiteren Leiterplattenschicht werden Ausnehmungen vorzugsweise in Form von Durchkontaktierungen, beispielsweise mittels Laserbohren, erzeugt. Diese Ausnehmungen erstrecken sich bis hin zu der Anschlußfläche des Chips und der Leiterstrktur, die auf der Leiterplattenbodenschicht verläuft. Es folgt eine Kontaktierung der Anschlußfläche des eingebetteten Chips oder Bauelements sowie der Leiterstruktur, die auf der Leiterplattenbodenschicht verläuft, durch eine vorzugsweise strukturierte Kontaktierungsleiterschicht.

Die Erfindung schafft daher eine Systemintegration innerhalb der Leiterplatte und wendet sich daher von dem bisherigen Ansatz ab, Systeme (auf) der Leiterplatte zu schaffen.

Ein Vorteil der vorliegenden Erfindung besteht darin, daß keine Kavitäten in Chips eingebracht werden müssen, was aufwendig ist und zudem einen erhöhten Ausschuß mit sich bringen kann. Darüberhinaus können Chips mit beliebigen Dimensionen verwendet werden. Die Chips müssen nicht gleich groß sein.

Die für das erfindungsgemäße Verfahren erforderlichen Verfahrensschritte lassen sich mit gängigen Gerätschaften und Verfahren aus dem Bereich der heutigen Leiterplattentechnologien und Technologien bei der Herstellung integrierter Schaltungen bewerkstelligen.

So werden die Chips, die gängigerweise mit Aluminium-Anschlußflächen versehen sind, dadurch in einen kontaktierbaren Zustand gebracht, indem auf die Aluminium-Anschlußflächen eine kontaktierbare Metalllage aufgebracht bzw. abgeschieden wird. Für die Metallisierung bieten sich neben konventionellen Verfahren, wie z.B. dem Galvanischen Verfahren oder Sputtern, auch das sog. "Nickel-Bumping" an. Bei dem Nickel-Bumping kann auf die Verwendung von Maskentechniken verzichtet werden. Die soweit vorbereiteten Chips werden auf ihrer den Anschlußflächen abgewandten Seite gedünnt. Für das Dünnen kommen sowohl mechnische Schleifverfahren wie auch chemische Ätzverfahren in Betracht. Selbstredend muß bei Einsatz von chemischen Verfahren für eine Abdeckung der zu bewahrenden Strukturen gesorgt werden.

Sodann wird der gedünnte Chip auf die Leiterplattenbodenschicht aufgebracht.

Der Chip kann beispielsweise mit seiner Rückseite, also der den Anschlußflächen gegenüberliegenden Seite, auf die Leiterplattenbodenschicht gebondet werden. Hierzu kann ein an sich übliches Klebeverfahren Anwendung finden, wie es derzeit beispielsweise beim sog. "Die-Bonding" Einsatz findet. Hierfür können marktübliche Geräte, nämlich sog. "Die-Bonder", eingesetzt werden. Im Falle sehr stark gedünnter Chips mit 50 µm Dicke oder gar geringerer Dicke bedarf es einer Anpassung der Anlageflächen und Kräfte bei der "Die-Bond-Montage".

In einem anschließenden Schritt wird eine weitere Leiterplattenschicht, die den ungehäusten Chip umhüllt, auf die Leiterplattenbodenschicht aufgebracht. Als Aufbringungsverfahren kommt Laminieren, Spin-Coating oder auch sog. "Vorhanggießen" eines flüssigen Dielektrikums in Betracht. Auch kann das Einbetten des montierten Chips durch Aufbringen einer kupferkaschierten Prepreg-Lage erfolgen. Gleichfalls kommt es in Betracht, ein beliebiges flüssiges Epoxid-Dielektrikum aufzugießen.

Durch diese weitere Dielektrikumsschicht bzw. Leiterplattenschicht müssen Durchkontaktierungen (sog. "Vias") erzeugt werden. Je nach eingesetztem Dielektrikum-Material erfolgt ein sog. "Sackloch-Bohren" durch ein Epoxid-Harz bzw. durch die Kupferlage und das Epoxid bzw. allgemein durch die weitere Leiterplattenschicht bis hin zu der Leiterplattenstruktur auf der Leiterplattenbodenschicht. Hierfür erweist sich das Laserbohren als das Verfahren mit der höchsten Flexibilität.

Nach dem Herstellen der Ausnehmungen bzw. Vias werden die Wände der Bohrungen chemisch aktiviert, woraufhin analog zur üblichen Verfahrensweise bei der Leiterplattentechnik eine chemische oder chemisch/galvanische Kupferabscheidung vorgenommen wird. Diese Kupferabscheidung bewirkt eine elektrische Verbindung der Leiterstruktur mit den Anschlußflächen der Chips. Anstelle der Kupferabscheidung kann auch die Abscheidung eines anderen Leitermaterials oder das Aufbringen einer Kontaktierungsleiterstruktur mittels anderer Verfahren als Metallabscheidungsverfahren, erfolgen. Nur beispielhaft sei hier das Aufdrucken einer Leiterstruktur genannt.

Vorzugsweise werden mehrdimensional hochintegrierte Schaltungsstrukturen mit mehreren weiteren Leiterplattenschichten, die jeweils wenigstens einen Chip umhüllen, und die jeweils ihre eigene Kontaktierungsleiterstruktur aufweisen, durch wiederholtes Durchführen der Schritte des Aufbringens des Chips auf die vorhandene Struktur, des Aufbringens der umhüllenden weiteren Leiterplattenschicht, des Erzeugens von Ausnehmungen und des Aufbringens der Kontaktierungsleiterstruktur erzeugt.

Kurz gesagt besteht ein wesentlicher Erfindungsaspekt in einem mehrfachen Ausführen des beschriebenen Verfahrens zur Schaffen einer dreidimensionalen Struktur, wobei jeweils die im vorherigen Verfahrensdurchlauf geschaffene Struktur als Leiterplattenbodenschicht für eine darauffolgende Schicht bestehend aus Leiterplattenschicht mit eingebettetem Chip und darüberliegender Kontaktierungsleiterstruktur dient.

Ein Teilaspekt des vorab beschriebenen Verfahrens wird nachfolgend unter Bezugnahme auf die beiliegenden Zeichnungen näher erläutert. Es zeigen:
- Fig. 1: den Schritt des Aufbringens eines Chips auf eine Leiterplattenbodenschicht;
- Fig. 2: den Schritt des Erzeugens einer weiteren Leiterplattenschicht;
- Fig. 3: den Schritt des Erzeugens von Ausnehmungen; und
- Fig. 4: den Schritt des Aufbringens einer Kontaktierungsleiterstruktur.

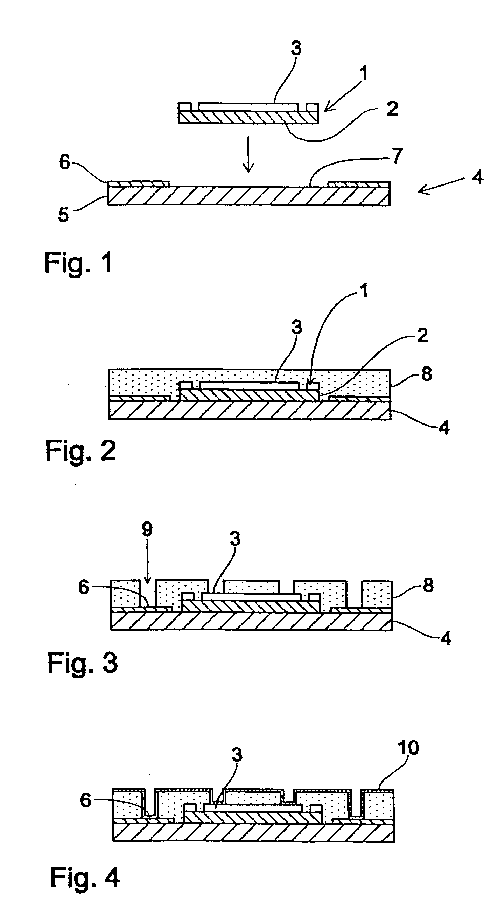

Wie in Fig. 1 gezeigt ist, wird ein Chip, der in seiner Gesamtheit mit dem Bezugszeichen 1 bezeichnet ist, und an seiner Rückseite 2 gedünnt ist, und der auf seiner Vorderseite Anschlußflächen 3 aufweist, welche 3 über einer Aluminiumschicht eine Kontaktierungsmetallschicht aufweisen, auf eine Leiterplattenbodenschicht 4 aufgesetzt. Die Leiterplattenbodenschicht hat ihrerseits eine Dielektrikumsschicht 5 und eine sich auf deren Oberfläche über Teilbereiche erstreckende Leiterstruktur 6, welche einen Bondbereich 7 freiläßt, an dem die Rückseite 2 des Chips 1 durch eine Die-Bondung mit der Leiterplattenbodenschicht 4 versehen wird.

Wie in Fig. 2 gezeigt ist, wird diese Struktur mit einer weiteren Dielektrikumsschicht 8 abgedeckt, welche den Chip 1 umgibt.

In Fig. 3 ist das Erzeugen von Durchkontaktierungen oder Vias mittels Laserbohrens gezeigt. Die Sachlöcher 9 erstrecken sich bis zu der Leiterstruktur 6 auf der Leiterplattenbodenschicht 4 bzw. bis zu den Anschlußflächen 3 des Chips 1.

Wie in Fig. 4 verdeutlicht ist, erfolgt eine abschließende Kontaktierung durch chemische oder galvanische Abscheidung einer Kupferschicht 10, welche sich bis zu der Leiterstruktur 6 bzw. der Anschlußfläche 3 erstreckt.
Allgemein erfolgt bei dem erfindungsgemäßen Verfahren zum Integrieren eines Chips 1 innerhalb einer Leiterplatte zunächst ein rückseitiges Dünnen des ungehäusten Chips 1 mit wenigstens einer Anschlußfläche auf seiner der Anschlußfläche 3 abgewandten Rückseite 2. Sodann werden die gedünnten, ungehäusten Chips 1 auf eine bereits mit Leiterstrukturen 6 versehene Leiterplattenbodenschicht 4 aufgebracht. Bei dem Chip 1 kann es sich bevorzugt um einen auf seiner den Anschlußflächen gegenüberliegenden Seite gedünnten Chip 1 handeln, der vorzugsweise auf seinen Anschlußflächen 3 mit einer zusätzlichen kontaktierbaren Metalllage versehen ist. Innerhalb der weiteren Leiterplattenschicht werden Ausnehmungen vorzugsweise in Form von Durchkontaktierungen, beispielsweise mittels Laserbohren, erzeugt. Diese Ausnehmungen erstrecken sich bis hin zu der Anschlußfläche 3 des Chips 1 und der Leiterstrktur, die auf der Leiterplattenbodenschicht 4 verläuft. Es folgt eine Kontaktierung der Anschlußfläche 3 des eingebetteten Chips 1 oder Bauelements sowie der Leiterstruktur, die auf der Leiterplattenbodenschicht 4 verläuft, durch eine vorzugsweise strukturierte Kontaktierungsleiterschicht.

Die Erfindung schafft daher eine Systemintegration innerhalb der Leiterplatte und wendet sich daher von dem bisherigen Ansatz ab, Systeme (auf) der Leiterplatte zu schaffen.

Die für das erfindungsgemäße Verfahren erforderlichen Verfahrensschritte lassen sich mit gängigen Gerätschaften und Verfahren aus dem Bereich der heutigen Leiterplattentechnologien und Technologien bei der Herstellung integrierter Schaltungen bewerkstelligen.

So werden die Chips 1, die gängigerweise mit Aluminium-Anschlußflächen versehen sind, dadurch in einen kontaktierbaren Zustand gebracht, indem auf die Aluminium-Anschlußflächen eine Kontaktierbare Metalllage aufgebracht bzw. abgeschieden wird.

Für die Metallisierung kommen galvanische Verfahren, Sputtern und das sog. "Nickel-Bumping" in Betracht. Bei dem Nickel-Bumping kann auf die Verwendung von Maskentechniken verzichtet werden. Die soweit vorbereiteten Chips 1 werden auf ihrer den Anschlußflächen 3 abgewandten Seite gedünnt. Für das Dünnen kommen sowohl mechanische Schleifverfahren wie auch chemische Ätzverfahren in Betracht. Selbstredend muß bei Einsatz von chemischen Verfahren für eine Abdeckung der zu bewahrenden Strukturen gesorgt werden.

Bei dem Aufbringen der gedünnten Chips 1 auf die Leiterplattenbodenschicht 4 können diese beispielsweise mit ihrer Rückseite 2, also der den Anschlußflächen 3 gegenüberliegenden Seite, auf die Leiterplattenbodenschicht 4 gebondet werden. Hierzu kann ein an sich übliches Klebeverfahren Anwendung finden, wie es derzeit beispielsweise beim sog. "Die-Bonding" Einsatz findet. Hierfür können marktübliche Geräte, nämlich sog. "Die-Bonder", eingesetzt werden. Im Falle sehr stark gedünnter Chips 1 mit 50 µm Dicke oder gar geringerer Dicke bedarf es einer Anpassung der Anlageflächen und Kräfte bei der "Die-Bond- Montage".

Bei dem darauffolgenden Schritt wird die weitere Leiterplattenschicht 5, die den ungehäusten Chip 1 umhüllt, auf die Leiterplattenbodenschicht 4 aufgebracht. Als Aufbringungsverfahren für die weitere Leiterplattenschicht 5 kommen Laminieren, Spin-Coating oder auch sog. "Vorhanggießen" eines flüssigen Dielektrikums in Betracht. Auch kann das Einbetten des montierten Chips 1 durch Aufbringen einer kupferkaschierten Prepreg-Lage erfolgen. Gleichfalls kommt es in Betracht, ein beliebiges flüssiges Epoxid-Dielektrikum aufzugießen.

Das Durchkontaktieren bzw. Erzeugen von sog. "Vias" durch diese weitere Dielektrikumsschicht bzw. Leiterplattenschicht erfolgt je nach eingesetztem Dielektrikum-Material durch sogenanntes "Sackloch-Bohren" durch ein Epoxid-Harz bzw. durch die Kupferlage und das Epoxid hindurch bzw. allgemein durch die weitere Leiterplattenschicht bis hin zu der Leiterstruktur 6 auf der Leiterplattenbodenschicht 4. Hierfür erweist sich das Laserbohren als das Verfahren mit der höchsten Flexibilität.

Nach dem Herstellen der Ausnehmungen bzw. Vias werden die Wände der Bohrungen chemisch aktiviert, woraufhin analog zur üblichen Verfahrensweise bei der Leiterplattentechnik eine chemische oder chemisch/galvanische Kupferabscheidung vorgenommen wird. Diese Kupferabscheidung bewirkt eine elektrische Verbindung der Leiterstruktur 6 mit den Anschlußflächen 3 der Chips 1. Anstelle der Kupferabscheidung kann auch die Abscheidung eines anderen Leitermaterials oder das Aufbringen einer Kontaktierungsleiterstruktur mittels anderer Verfahren als Metallabscheidungsverfahren, erfolgen. Nur beispielhaft sei hier das Aufdrucken einer Leiterstruktur genannt.

Vorzugsweise werden mehrdimensional hochintegrierte Schaltungsstrukturen mit mehreren weiteren Leiterplattenschichten 5, die jeweils wenigstens einen Chip 1 umhüllen, und die jeweils ihre eigene Kontaktierungsleiterstruktur 6 aufweisen, durch wiederholtes Durchführen der Schritte des Aufbringens des Chips 1 auf die vorhandene Struktur 4, des Aufbringens der umhüllenden weiteren Leiterplattenschicht 5, des Erzeugens von Ausnehmungen und des Aufbringens der Kontaktierungsleiterstruktur 10 erzeugt.

Ein wesentlicher Erfindungsaspekt liegt in einem mehrfachen Ausführen des beschriebenen Verfahrens zur Schaffen einer dreidimensionalen Struktur, wobei jeweils die im vorherigen Verfahrensdurchlauf geschaffene Struktur als Leiterplattenbodenschicht 4 für eine darauffolgende Schicht bestehend aus Leiterplattenschicht mit eingebettetem Chip 1 und darüberliegender Kontaktierungsleiterstruktur 10 dient.

## Patentansprüche

1. Verfahren zum Integrieren eines Chips (1) innerhalb einer Leiterplatte, die zumindest eine Leiterplattenbodenschicht (4) und eine weitere Leiterplattenschicht (8) umfaßt, mit folgenden Schritten:
a) Rückseitiges Dünnen des ungehäusten Chips (1) mit wenigstens einer Anschlußfläche (3) auf seiner der Anschlußfläche (3) abgewandten Rückseite (2);
b) Aufbringen des ungehäusten Chips (1) mit dessen Rückseite (2) auf die eine Leiterstruktur (6) aufweisende Leiterplattenbodenschicht (4) der Leiterplatte;
c) Aufbringen der weiteren Leiterplattenschicht (8) auf die Leiterplattenbodenschicht (4), auf der der ungehäuste Chip (1) angeordnet ist, um den ungehäusten Chip (1) in die Leiterplatte einzubetten;
d) Erzeugen von sich durch die weitere Leiterplattenschicht (8) bis zu der Anschlußfläche (3) und zu der Leiterstruktur (6) erstreckenden Ausnehmungen (9), und
e) Aufbringen einer Kontaktierungsleiterstruktur (10) auf die weitere Leiterplattenschicht (8), welche sich über die Ausnehmungen (9) bis zu der Anschlußfläche (3) und der Leiterstruktur (6) erstreckt.

2. Verfahren nach Anspruch 1, mit folgendem anfänglichen Verfahrensschritt:
- Aufbringen einer kontaktierbaren Metalllage auf die Anschlußfläche (3) des Chips (1).

3. Verfahren nach Anspruch 1 oder 2, zum Integrieren des Chips innerhalb einer mehrschichtigen, dreidimensionalen Struktur,
bei dem die Verfahrensschritte a) bis e) für jede weitere Schicht der Leiterplatte wiederholt werden, wobei jeweils die sich nach dem Schritt e) ergebende Struktur die Leiterplattenbodenschicht (4) bildet, auf der die darauffolgende Schicht aufgebaut wird.

4. verfahren nach einem der Ansprüche 1 bis 3, bei dem die Leiterplattenbodenschicht eine Dielektrikumschicht (5) und eine Leiterstruktur (6) aufweist, und wobei in der Dielektrikumschicht (5) der Leiterplattenbodenschicht keine Aussparung für den Chip (1) vorhanden ist.

5. Verfahren nach einem der Ansprüche 1 bis 4, bei dem im Schritt des Erzeugens der Ausnehmungen die Ausnehmungen (9) derart erzeugt werden, daß sie sich nicht durch den Chip (1) erstrecken.

6. integrierte Schaltung mit folgenden Merkmalen:
einem rückseitig gedünnten ungehäusten Chip (1) mit wenigstens einer Anschlußfläche (3) auf seiner Vorderseite;
eine Leiterplatte mit einer Leiterplattenbodenschicht (4) die eine Dielektrikumschicht (5) und eine Leiterstruktur (6) aufweist, wobei der Chip mit seiner Rückseite auf der Leiterplattenbodenschicht (4) aufgebracht ist, und wobei in der Dielektrikumschicht (5) der Leiterplattenbodenschicht keine Aussparung für den Chip (1) vorhanden ist;
einer weiteren Leiterplattenschicht (8), die auf der Leiterplattenbodenschicht (4) angeordnet ist und den Chip (1) in die Seiterplatte einhettet;
Ausnehmungen (9), die sich durch die weitere Leiterplattenschicht (8) bis zu der Anschlußfläche (3) und zu der Leiterstruktur (6) und nicht durch den Chip (1) erstrecken; und
einer Kontaktierungsleiterstruktur (10), die auf der weiteren Leiterplattenschicht (8) angeordnet ist, welche sich über die Ausnehmungen (9) bis zu der Anschlußfläche (3) und der Leiterstruktur (6) erstreckt.

## Claims

1. Method for integrating a chip (1) within a printed circuit board including at least a printed circuit board bottom layer (4) and a further printed circuit board layer (8), comprising:
a) rear-thinning said unhoused chip (1) comprising at least one pad (3) on its back side (2) facing away from said pad (3);
b) applying said unhoused chip (1) with its back side (2) to said printed circuit board bottom layer (4) of said printed circuit board, comprising a conductive pattern (6);
c) applying said further printed circuit board layer (8) to said printed circuit board bottom layer (4) on which said unhoused chip (1) is arranged, to embed said unhoused chip (1) into said printed circuit board;
d) producing recesses (9) extending through the further printed circuit board layer (8) to the pad (3) and to the conductive pattern (6), and
e) applying a contacting conductive pattern (10) to said further printed circuit board layer (8), said pattern (10) extending, via said recesses (9), to said pad (3) and to said conductive pattern (6).

2. Method according to claim 1, comprising the following initial method step:
- applying a contactable metal sheet to said pad (3) of said chip (1).

3. Method according to claims 1 or 2, for integrating the chip within a multi-layered three-dimensional structure,
wherein the method steps a) to e) are repeated for each further layer of the printed circuit board, the respective structure resulting after step e) forming the printed circuit board bottom layer (4) onto which the following layer is formed.

4. Method according to one of claims 1 to 3, in which said printed circuit board bottom layer comprises a dielectric layer (5) and a conductive pattern (6), and in which there is no recess for the chip (1) in the dielectric layer (5) of said printed circuit board bottom layer.

5. Method according to one of claims 1 to 4, in which in the step of producing the recesses said recesses (9) are produced such that same do not extend through the chip (1).

6. Integrated circuit comprising:
a rear-thinned unhoused chip (1) comprising at least one pad (3) on its front side;
a printed circuit board comprising a printed circuit board bottom layer (4) comprising a dielectric layer (5) and a conductive pattern (6), said chip being applied to said printed circuit board bottom layer (4) with its back side, wherein there is no recess for said chip (1) in said dielectric layer (5) of said printed circuit board bottom layer;
a further printed circuit board layer (8) arranged on said printed circuit board bottom layer (4) and
embedding said chip (1) in said printed circuit board;
recesses (9) extending through said further printed circuit board layer (8) to said pad (3) and to said conductive pattern (6) and not through said chip (1); and
a contacting conductive structure (10) arranged on said further printed circuit board layer (8), said structure extending, via said recesses (9), to said pad (3) and to said conductive pattern (6).

## Revendications

1. Procédé d'intégration d'une puce (1) dans une plaquette de circuit imprimé, comportant au moins une couche de fond de plaquette de circuit imprimé (4) et une autre couche de plaquette de circuit imprimé (8), aux étapes suivantes consistant à :
(a) amincir du côté arrière la puce sans boîtier (1) avec au moins une surface de raccordement (3) sur sa face arrière (2) éloignée de la surface de raccordement (3) ;
(b) appliquer la puce sans boîtier (1), par sa face arrière (2), sur la couche de fond de plaquette de circuit imprimé (4) présentant une structure conductrice (6) ;
(c) appliquer l'autre couche de plaquette de circuit imprimé (8) sur la couche de fond de plaquette de circuit imprimé (4) sur laquelle est disposée la puce sans boîtier (1), pour enrober la puce sans boîtier (1) dans la plaquette de circuit imprimé ;
(d) générer des évidements (9) s'étendant à travers l'autre couche de plaquette de circuit imprimé (8) jusqu'à la surface de raccordement (3) et jusqu'à la structure conductrice (6), et
(e) appliquer une structure conductrice de mise en contact (10) sur l'autre couche de plaquette de circuit imprimé (8), laquelle s'étend au-dessus des évidements (9) jusqu'à la surface de raccordement (3) et la structure conductrice (6).

2. Procédé selon la revendication 1, à l'étape de procédé initiale suivante consistant à :
- appliquer une couche métallique pouvant établir un contact sur la surface de raccordement (3) de la puce (1).

3. Procédé selon la revendication 1 ou 2, pour intégrer la puce dans une structure tridimensionnelle à couches multiples,
dans lequel les étapes de procédé a) à e) sont répétées pour chaque autre couche de la plaquette de circuit imprimé, la structure résultant après chaque étape e) constituant la couche de fond de plaquette de circuit imprimé (4) sur laquelle est construite la couche suivante.

4. Procédé selon l'une des revendications 1 à 3, dans lequel la couche de fond de plaquette de circuit imprimé présente une couche de diélectrique (5) et une structure conductrice (6), et dans la couche de diélectrique (5) de la couche de fond de plaquette de circuit imprimé n'étant pas présent d'évidement pour la puce (1).

5. Procédé selon l'une des revendications 1 à 4, dans lequel, à l'étape de génération des évidements, les évidements (9) sont générés de sorte qu'ils ne s'étendent pas à travers la puce (1).

6. Circuit intégré aux caractéristiques suivantes :
une puce sans boîtier (1) amincie du côté arrière avec au moins une surface de raccordement (3) sur sa face avant ;
une plaque de circuit imprimé avec une couche de fond de plaquette de circuit imprimé (4) présentant une couche de diélectrique (5) et une structure conductrice (6), la puce étant appliquée par sa face arrière sur la de fond de plaquette de circuit imprimé (4), et dans la couche de diélectrique (5) de la couche de fond de plaquette de circuit imprimé (4) n'étant pas présent d'évidement pour la puce (1) ;
une autre couche de plaquette de circuit imprimé (8) qui est disposée sur la couche de fond de plaquette de circuit imprimé (4) et enrobe la puce (1) dans la plaquette de circuit imprimé ;
des évidements (9) qui s'étendent à travers l'autre couche de plaquette de circuit imprimé (8), jusqu'à la surface de raccordement (3) et jusqu'à la structure conductrice (6) et non pas à travers la puce (1) ; et
une structure conductrice de mise en contact (10), disposée sur l'autre couche de plaquette de circuit imprimé (8), qui s'étend au-dessus des évidements (9) jusqu'à la surface de raccordement (3) et la structure conductrice (6).
